# EUROPÄISCHE PATENTSCHRIFT

(11) **EP 0 284 908 B1**
(45) Veröffentlichungstag und Bekanntmachung des Hinweises auf die Patenterteilung: **27.10.1993**
(21) Anmeldenummer: 88104289.9
(22) Anmeldetag: 17.03.1988
(51) Int. Cl.: H01S 3/133, H01L 27/15, G02B 6/42

(54) **Anordnung zur Steuerung oder Regelung einer Emissionswellenlänge und emittierten Leistung eines Halbleiterlasers**
Arrangement to control or adjust an emission-wavelength and an emitted power of a semiconductor laser
Agencement pour contrôle ou réglage d'une longueur d'onde émise et pour émission d'un laser à semi-conducteur

(30) Priorität: 30.03.1987 DE 3710545
(43) Veröffentlichungstag der Anmeldung: 05.10.1988
(73) Patentinhaber: SIEMENS AKTIENGESELLSCHAFT, 80333 München (DE)
(72) Erfinder: Schienle, Meinrad, Dr., D-8000 München 83 (DE); März, Reinhard, Dr., D-8000 München 80 (DE); Mahlein, Hans-F., Dr., D-8025 Unterhaching (DE)

(56) Entgegenhaltungen:
- EP-A- 0 001 714
- PATENT ABSTRACTS OF JAPAN, Band 9, Nr. 118 (E-316)[1841], 23. Mai 1985; & JP-A-60 7233 (TOSHIBA K.K.) 16-01-1985
- PATENT ABSTRACTS OF JAPAN, Band 8, Nr. 13 (E-222)[1450], 20. Januar 1984; & JP-A-58 175 881 (KOGYO GIJUTSUIN) 15-10-1983
- PATENT ABSTRACTS OF JAPAN, Band 10, Nr. 20 (E-376)[2077], 25. Januar 1986; & JP-A-60 180 184 (MATSUSHITA DENKI SANGYO K.K.)13-09-1985

## Beschreibung

Die Erfindung betrifft gemäß dem Oberbegriff des Patentanspruchs 1 eine Anordnung zur Steuerung oder Regelung einer Emissionswellenlänge und emittierten Leistung eines Halbleiterlasers. Eine solche Anordnung ist in EP-A-0 001 714 beschrieben.

Bei zahlreichen Anwendungen von Halbleiterlaserdioden, beispielsweise im Wellenlängenmultiplex, insbesondere bei kleinen Kanalabständen, beim optischen Frequenzmultiplex oder dem optischen Heterodynempfang, sind Laserdioden mit stabiler oder regelbarer Emissionswellenlänge oder konstanter emittierter optischer Leistung notwendig.

Bei den derzeit vorhandenen transversal und longitudinal monomodigen Laserdioden, beispielsweise DFB- oder DBR-Lasern, werden durch Temperaturdrift, Änderungen des Schwellstromes und Degradation kleine Verschiebungen der Emissionswellenlänge verursacht, die z.B. im Zusammenwirken mit schmalbandigen optischen Filtern stören. Weiterhin variiert die optische Ausgangsleistung durch Alterungsprozesse.

Bisher gelang eine Stabilisierung bzw. Regelung der Emissionswellenlänge von Halbleiterlasern nur mit komplizierten Anordnungen über externe Resonatoren und extreme Temperaturstabilisierung, die nicht für integriert optische Anordnungen geeignet sind und im Stabilisierungsgrad nicht ausreichen.

Aufgabe der Erfindung ist es, eine Anordnung der eingangs genannten Art zu schaffen, die sich integriert optisch ausführen und herstellen läßt und mit der die Emissionswellenlänge und emittierte optische Leistung des Halbleiterlasers simultan gesteuert oder geregelt werden kann.

Diese Aufgabe wird durch die im kennzeichnenden Teil des Patentanspruchs 1 angegebenen Merkmale gelöst.

Bei der erfindungsgemäßen Anordnung können mit den beiden optoelektrischen Detektoreinrichtungen und der wellenlängenselektiven optischen Filtereinrichtung gleichzeitig die emittierte optische Leistung des Lasers und seine Emissionswellenlänge gemessen, und dadurch zwei Regelsignale für den Injektionsstrom des Halbleiterlasers erhalten werden. Die erfindungsgemäße Anordnung ist in monolithischer Integration ausgeführt.

Die Filtereinrichtung weist vorzugsweise eine Transmissionskurve nach Maßgabe des Anspruchs 2 auf. Je steiler der Anstieg oder Abfall der Transmissionskurve in dem bestimmten Wellenlängenbereich ist, in den die Emissionswellenlänge des Lasers fällt, desto genauer läßt sich diese Emissionswellenlänge stabilisieren, weil bei großer Steigung eine kleine Änderung der Emissionswellenlänge des Lasers eine große Änderung des Signalstroms der einen optoelektrischen Detektoreinrichtung bewirkt. Demnach ist eine Anordnung nach Anspruch 2 mit steilem Anstieg und/oder Abfall der Transmissionskurve über dem bestimmten Wellenlängenbereich, in den die Emissionswellenlänge fällt, vorteilhaft zur Stabilisierung der Emissionswellenlänge des Lasers verwendbar.

Besonders zweckmäßig ist es dabei, wenn gemäß Anspruch 3 die Transmissionskurve eine Spitze, zweckmäßigerweise eine Spitze nach Anspruch 4 aufweist. Mit derartigen Spitzen kann eine extrem genaue Stabilisierung der Emissionswellenlänge erreicht werden, wobei die zu stabilisierende Emissionswellenlänge in der Spitze oder auf einer ihrer beiden Flanken liegen kann.

Eine erfindungsgemäße Anordnung nach einem der Ansprüche 2 bis 4 ist auch für ein Durchstimmen der Emissionswellenlänge eines Halbleiterlasers verwendbar, wie es für optisches Frequenzmultiplex oder Heterodynempfang interessant ist. In einem solchen Fall ist ein flacherer Anstieg und/oder Abfall der Transmissionskurve in dem bestimmten Wellenlängenbereich, in den die Emissionswellenlänge fällt, günstiger, da dadurch ein größerer Abstimmbereich erzielt wird. Die Größe des Abstimmbereiches wird dann durch die Abstimmcharakteristik des Lasers bestimmt.

Die Filtereinrichtung der Anordnung kann zur Realisierung spezieller Filtercharakteristiken aus zwei oder mehreren in Ausbreitungsrichtung der zugeleiteten optischen Leistung hintereinander angeordneten einzelnen optischen Filterelementen bestchen.

Als Filterelemente sind Bragg-Gitter, ko- oder kontradirektionale Richtkoppler oder auch Interferenzfilter geeignet (Ansprüche 6 bis 8). Zur Realisierung spezieller Filtercharakteristiken sind auch Gitter mit variierender Gitterkonstante bzw. Gitter mit Chirp (Anspruch 5) von Interesse. Die Größe des obengenannten Abstimmbereichs läßt sich über die Länge des Gitters beeinflussen. Je kürzer das Gitter ist, desto größer ist der Abstimmungsbereich. Ein größerer Abstimmbereich läßt sich auch durch ein Gitter mit Chirp erreichen.

Eine vorteilhafte Realisierung einer Anordung, bei der die Transmissionskurve der Filtereinrichtung ein spitzes Transmissionsmaximum aufweist, und die eine extrem genaue Stabilisierung der Emissionswellenlänge ermöglicht, ist im Anspruch 6 angegeben.

Der Abstimmbereich einer erfindungsgemäßen Anordnung läßt dadurch vergrößern, daß mehrere parallel geschaltete Filtereinrichtungen nach Maßgabe des Anspruchs 9 vorgesehen werden, wobei spezielle Ausgestaltungen dieser Anordnung aus den Ansprüchen 10 und 11 hervorgehen.

Eine Anordnung mit Bragg-Gittern wird vorzugsweise so ausgebildet, wie es im Anspruch 12 angegeben ist. Um Rückwirkungen der an der Filtereinrichtung reflektierten optischen Leistung auf den Laser zu vermeiden, ist es zweckmäßig, wenn die eine teildurchlässige Detektoreinrichtung gemäß Anspruch 13 mehr als 95 % der ihr zugeleiteten Leistung absorbiert. Bei einer Absorption von etwa 97 % dieser Leistung wird die reflektierte und auf den Laser rückwirkende optische Leistung um mehr als 30 dB gedämpft. Vorzugsweise ist die eine teildurchlässige Detektoreinrichtung in Form einer Fotodiode ausgebildet. Die gewünschte Absorption einer solchen Diode ist über ihre Geometrie sowie über die Zusammensetzung und Dotierung einer absorbierenden Schicht dieser Diode wählbar.

Eine Anordnung kann auch so ausgebildet sein, wie es im Anspruch 14 angegeben ist. Dabei wird vorzugsweise in einem Transmissionsmaximum der Filtereinrichtung gearbeitet, beispielsweise die Emissionswellenlänge des Lasers in der bereits erwähnten Spitze stabilisiert und die Detektoreinrichtungen sollen eine möglichst hohe Transmission aufweisen. Die Anordnung nach Anspruch 14 ist auf der gleichen Seite des Lasers angeordnet, auf der die Ausgangsleistung entnommen wird, im Gegensatz zur Anordnung nach Anspruch 12 oder 13.

Eine vorteilhafte Weiterbildung einer erfindungsgemäßen Anordnung ist im Anspruch 16 angegeben, die eine bidirektionale Wellenlängen-Multiplex/Demultiplexanordnung bildet und insbesondere in der Form nach Anspruch 21 monolithisch integrierbar ist. Die der Empfängerdetektoreinrichtung vorgeschaltete Filtereinrichtung kann von derselben Art wie die oder eine der Filtereinrichtungen der Anordnung zur Steuerung oder Regelung der Emissionswellenlänge und emittierten optischen Leistung des Lasers sein. Beispielsweise kann die der Empfängerdetektoreinrichtung vorgeschaltete Filtereinrichtung wie die andere Filtereinrichtung ein Bragg-Gitter sein, dessen Gitterkonstante jedoch so gewählt ist, daß sich eine Verstimmung zwischen den beiden Transmissionskurven dieser beiden Filtereinrichtungen um eine halbe Sperrbandbreite ergibt. Eine Regelschaltung, wie sie noch angegeben wird, kann dann die Emissionswellenlänge des Lasers auf die Mitte des Sperrbandes des der Empfängerdetektoreinrichtung vorgeschalteten Bragg-Gitters abstimmen. Die Temperaturdriften der beiden Bragg-Gitter kompensieren sich, wenn ihr räumlicher Abstand zum Laser etwa gleich groß gewählt wird. Alterungsbedingte Änderungen der Emissionswellenlänge des Lasers werden ebenfalls ausgeregelt.

Eine zweckmäßige Weiterbildung der erfindungsgemäßen Anordnung, die eine Regelschaltung zur Regelung der Ausgangsleistung und der Emissionswellenlänge des Lasers umfaßt, geht aus Anspruch 18 hervor. Diese Regelschaltung ist insbesondere auch dazu geeignet, im Fall einer Anordnung nach Anspruch 16 oder 17 die Emissionswellenlänge des Lasers auf die Mitte des Sperrbandes des dortigen, der Empfänger-Detektor-Einrichtung vorgeschalteten Filtereinrichtung abzustimmen.

Eine bevorzugte Ausführungsform der Anordnung nach Anspruch 18, die eine Weiterbildung der Regelschaltung betrifft, ist im Anspruch 19 angegeben. Mit dieser Ausführungsform läßt sich der Arbeitspunkt des Lasers und damit auch seine Emissionswellenlänge variieren. Diese Ausführungsform ist insbesondere für den Fall günstig, bei dem der Abstimmbereich über einen größeren Abstimmbereich durchgestimmt werden muß.

Zusätzlich zur beschriebenen Abstimmung ist auch noch eine einfache Grobabstimmung realisierbar, wenn bei einer Anordnung nach Anspruch 18 oder 19 die im Anspruch 20 angegebenen Maßnahmen ergriffen werden. Durch das Zwischenschalten des Inverters zwischen die andere oder zumindest eine der anderen Detektoreinrichtung und den Regelverstärker der Anordnung kann eine Flanke der Transmissionskurve der betreffenden Filtereinrichtung gewechselt und dadurch die Emissionswellenlänge um den Abstand der beiden Flanken der Transmissionskurve geändert werden.

Besonders zu erwähnen ist, daß eine erfindungsgemäße Anordnung, insbesondere in der Ausgestaltung nach Anspruch 15, mit den Techniken der integrierten Optik auf III/V-Halbleitern realisierbar ist. Dies bedeutet, daß sowohl die optische Anordnung allein als auch ein elektrischer Teil, insbesondere eine Regelschaltung nach einem der Ansprüche 18 bis 20 gemeinsam monolithisch integriert in einem III/V-Halbleiter realisiert werden können.

Die Erfindung wird in der nun folgenden Beschreibung anhand der Figuren beispielhaft näher erläutert. Von den Figuren zeigen:
- Figur 1: eine Draufsicht auf eine Anordnung mit Regelschaltung in schematischer Darstellung,
- Figur 2: eine Transmissionskurve der Filtereinrichtung der Anordnung nach Figur 1,
- Figur 3: in Draufsicht eine Filtereinrichtung aus zwei in Serie angeordneten Bragg-Gittern mit Phasensprung,
- Figur 4: schematisch die Transmissionskurve mit Spitze der Filtereinrichtung nach Figur 3,
- Figur 5: in Draufsicht ein Bragg-Gitter mit Chirp,
- Figur 6: eine Draufsicht auf eine mit der Anordnung nach Figur 1 aufgebaute Wellenlängen-Multiplex/Demultiplex-Anordnung in schematischer Darstellung,
- Figur 7: den Regelverstärker der Regelschaltung nach Figur 1, wobei zwischen die eine Detektoreinrichtung und den Regelverstärker ein variabler Spannungsteiler geschaltet ist,
- Figur 8: den Regelverstärker der Regelschaltung nach Figur 1, wobei der variable Spannungsteiler zwischen die andere Detektoreinrichtung und den Regelverstärker geschaltet ist, und zusätzlich ein Inverter zwischen die eine Detektoreinrichtung und den Regelverstärker geschaltet ist,
- Figur 9: eine Draufsicht auf eine Ausführung einer Anordnung mit mehreren parallelen Filtereinrichtung zur Erweiterung des Abstimmbereichs in schematischer Darstellung,
- Figur 10: die überlagerten Transmissionskurven der Filtereinrichtungen der Ausführung nach Figur 9,
- Figur 11: eine Draufsicht auf eine Ausführungsform der Anordnung nach Figur 1 mit einem kodirektionalen optischen Richtkoppler als Filtereinrichtung in schematischer Darstellung,
- Figur 12: eine Draufsicht auf eine Anordnung nach Figur 1 mit einem kontradirektionalen Richtkoppler als Filtereinrichtung in schematischer Darstellung, und
- Figur 13: eine Ausführung einer Anordnung nach Figur 1 mit einem Interferenzfilter als Filtereinrichtung in schematischer Darstellung.

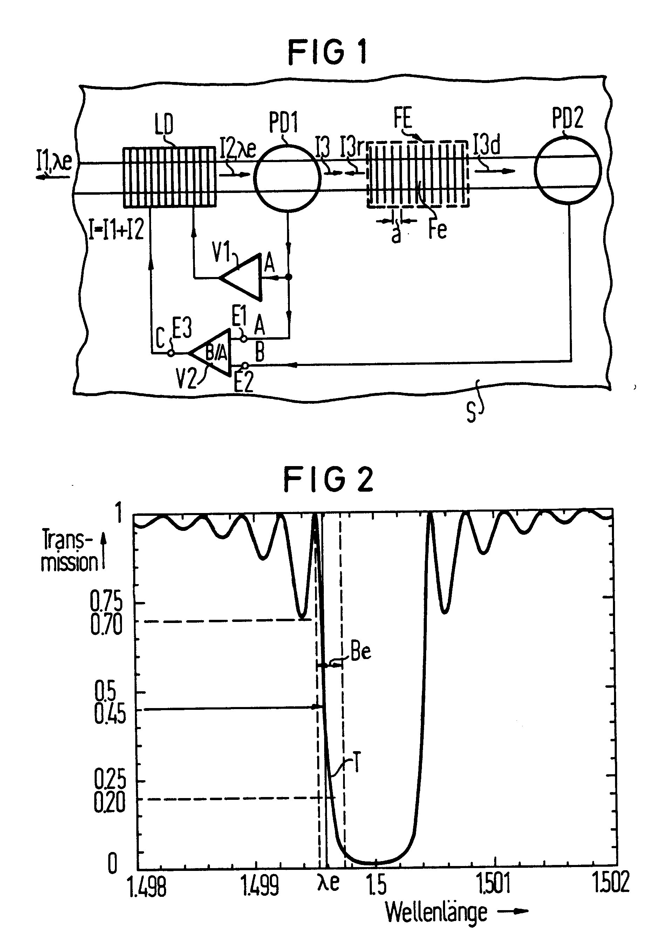

Bei der in Figur 1 dargestellten Anordnung sind der Halbleiterlaser LD in Form einer Laserdiode, die eine, teildurchlässig ausgebildete optoelektrische Detektoreinrichtung PD1 in Form einer Fotodiode, die aus einem Filterelement Fe in Form eines Bragg-Gitters bestehende Filtereinrichtung FE und die andere optoelektrische Detektoreinrichtung PD2 in Form einer Fotodiode durch einen gemeinsamen Streifenwellenleiter WL miteinander verbunden. Der Streifenwellenleiter WL ist auf einem Substrat S aus einem III/V-Halbleitermaterial ausgebildet, auf dem die ganze Anordnung einschließlich des aus einer Regelung bestehenden elektrischen Teils der Anordnung integriert ist.

Der Halbleiterlaser LD strahlt seine Ausgangsleistung I nach beiden Seiten aus. Der nach rechts ausgesandte Teil I2 der Ausgangsleistung I wird von der teildurchlässigen einen Detektoreinrichtung PD1 teilweise absorbiert. Ihr elektrisches Ausgangssignal wird über einen Verstärker V1 zur Leistungsstabilisierung des Halbleiterlasers LD verwendet.

Der durch die teildurchlässige eine Detektoreinrichtung PD1 hindurchgegangene Teil I3 der zugeleiteten optischen Leistung I2 gelangt auf die Filtereinrichtung FE und wird dort zum Teil reflektiert und zum Teil transmittiert.

Der durch die Filtereinrichtung FE hindurchgegangene Anteil I3d der Leistung I3 wird von der anderen Detektoreinrichtung PD2 detektiert.

Das elektrische Ausgangssignal B der anderen Detektoreinrichtung PD2 wird einem Eingang E2 eines Regelverstärkers V2 zugeleitet. Das elektrische Ausgangssignal A der einen Detektoreinrichtung PD1 wird nicht nur dem einen Verstärker V1 sondern auch einem anderen Eingang E1 des Regelverstärkers V2 zugeleitet.

Der Regelverstärker V2 gibt an einem Ausgang E3 ein elektrisches Ausgangssignal C aus, das proportional zum Quotienten B/A der beiden Signale B und A an den Eingängen E2 und E1 des Regelverstärkers V2 ist und das zur Kontrolle der Emissionswellenlänge λ e des Lasers LD verwendet wird.

In der Figur 2 ist ein Beispiel einer spektralen Transmissionskurve T einer aus einem Filterelement Fe in Form eines Bragg-Gitters ausgebildeten Filtereinrichtung FE dargestellt. Diese Kurve T weist über dem Wellenlängenbereich Be einen Abfall auf, d.h. über dem Bereich Be nimmt die Transmission des Filters mit zunehmender Wellenlänge ab, speziell von etwa 1 an der linken Grenze des Bereichs Be bis auf nahezu 0 an der rechten Grenze dieses Bereichs, welche zugleich eine linke Grenze eines Sperrbereichs des Filterelements bildet.

Der Laser LD und die Filtereinrichtung FE sind so zu wählen, daß die gewünschte Emissionswellenlänge λ e des Lasers LD in den Bereich Be der Transmissionskurve T fällt. Sie wird zweckmäßigerweise so gewählt, daß sie in einem Punkt besonders großer Steilheit des Abfalls der Transmissionskurve T fällt, der in der Figur 2 bei einer Transmission von etwa 0,45 liegt. Durch die große Steigung der Transmissionskurve T bei der gewünschten Emissionswellenlänge λ e des Lasers LD bewirkt eine kleine Änderung dieser Wellenlänge λ e eine große Änderung des Stromes in der einen Detektoreinrichtung PD2.

Aufgrund der großen Steilheit des Abfalls der Transmissionskurve T nach Figur 2 ist in dem Bereich Be eine Regelung der Emissionswellenlänge λ e auf 0,01 nm in einem Regelbereich von 0,1 nm möglich. Beispielsweise erfolgt bei der Transmissionskurve T der Abfall der Transmission von 0,7 auf 0,2 in einem Wellenlängenintervall von 0,06 nm. Wird angenommen, daß sich der Arbeitspunkt der Regelschleife auf 1 % stabilisieren läßt, so läßt sich bezüglich der Bragg-Wellenlänge des Gitters Fe eine Stabilisierung auf 10⁻³ erreichen. Die absolute Lage der Emissionswellenlänge λ e wird durch die Temperaturdrift der Bragg-Wellenlänge des Gitters Fe bestimmt, die durch die Temperaturabhängigkeit sowohl der Brechzahlen als auch der Gitterkonstanten a verursacht wird.

Obwohl dieselben Mechanismen auch für die Temperaturdrift bestimmter Laser, beispielsweise von DFB- und DBR-Laserdioden verantwortlich sind, ist zu erwarten, daß sie bei rein passiven Komponenten wesentlich leichter zu beherrschen sind, da die aktive Zone des Lasers stärkeren Temperaturschwankungen unterworfen ist und ihre Brechzahl auch vom Pumpzustand des Lasers abhängt.

Als abstimmbarer Halbleiterlaser LD eignet sich beispielsweise der von Dutta et al.(siehe Appl. Phys. Lett. 48 (1986) S. 1501) beschriebene DFB-Laser mit einem Abstimmbereich von etwa 0,2 nm oder der von Yamaguchi et al. (siehe Electron. Lett. 21 (1985) S. 63) beschriebene DBR-Laser mit einem Abstimmbereich von 4 nm.

Wird als Halbleiterlaser LD eine konventionelle DFB- oder DBR-Laserdiode verwendet, so können die beiden elektrischen Anschlüsse der Diode in einem einzigen Anschluß zusammengefaßt werden.

Um Rückwirkungen der am Bragg-Gitter Fe reflektierten Leistung I3r auf den Laser LD zu vermeiden, muß die Detektoreinrichtung PD1 etwa 97 % der im Streifenwellenleiter WL vorhandenen Leistung absorbieren, damit die auf den Laser LD reflektierte Leistung um mehr als 30 dB gedämpft wird. Wie schon erwähnt, ist die gewünschte Absorption der als Fotodiode ausgebildeten teildurchlässigen Detektoreinrichtung PD1 über die Geometrie der Diode sowie über die Zusammensetzung und Dotierung ihrer absorbierenden Schicht wählbar.

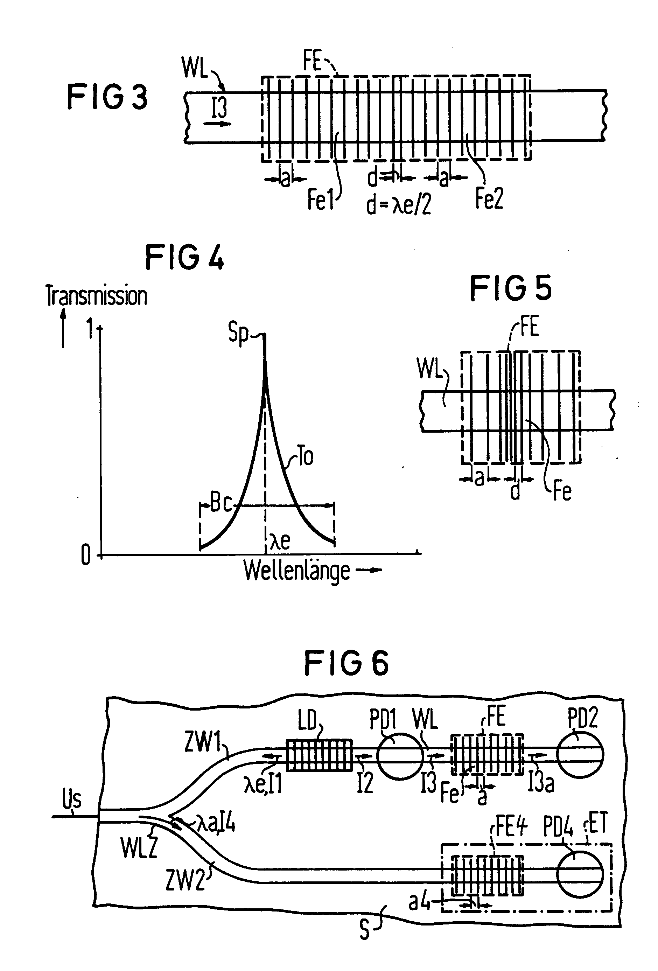

Wird statt eines einzigen Bragg-Gitters Fe eine Anordnung mit zwei oder mehreren Gittern in Serie gewählt, so lassen sich spezielle Filtercharakteristiken bzw. Transmissionskurven realisieren. Eine extrem genaue Stabilisierung der Emissionswellenlänge λ e des Lasers LD ist mit einer Filtereinrichtung FE nach Figur 3 möglich, bei der zwei Bragg-Gitter Fe₁ und Fe₂ in Serie angeordnet sind, deren Abstand d voneinander - bezogen auf die optische Weglänge des im Streifenwellenleiter WL geführten Modus - eine halbe Wellenlänge der geführten Leistung oder ein ganzzahliges Vielfaches dieser halben Wellenlänge beträgt. Diese beiden Bragg-Gitter bilden ein sogenanntes Gitter mit Phasensprung.

Die Transmissionskurve TO eines derartigen Gitters mit Phasensprung weist in einem bestimmten Wellenlängenbereich BO ein Transmissionsmaximum in Form einer Spitze Sp auf, wie sie in der Figur 4 prinzipiell angedeutet ist.

In diesem Fall kann der Arbeitspunkt des Lasers LD im Transmissionsmaximum oder auf einer seiner beiden, links oder rechts der Spitze Sp liegenden Anstiegs- oder Abfallsflanken liegen. Erfolgt eine Stabilisierung im Transmissionsmaximum, d.h. in der Spitze Sp, und werden Detektoreinrichtungen mit hoher Transmission benützt, so kann die Ausgangsleistung des Lasers auch auf der Seite entnommen werden, auf der sich die Anordnung befindet. Im Beispiel nach Figur 1 bedeutet dies, daß dann die Ausgangsleistung aus dem Streifenwellenleiter WL rechts von der anderen Detektoreinrichtung PD2 entnommen wird. Die linke Seite des Halbleiterlasers LD kann dann auch verspiegelt werden, so daß dort keine optische Leistung austritt, sondern die gesamte optische Leistung des Lasers LD nach rechts emittiert wird.

Spezielle Filtercharakteristiken lassen sich auch durch Bragg-Gitter mit Chirp realisieren. In der Figur 5 ist ein Beispiel einer Filtereinrichtung FE schematisch in Draufsicht dargestellt, die aus einem Bragg-Gitter Fe mit Chirp besteht, bei dem also die Gitterkonstante a variiert, beispielsweise gemäß einer vorbestimmten Funktion.

Ein Anwendungsbeispiel einer der vorstehend beschriebenen Anordnungen, speziell der Anordnung nach Figur 1, ist in Figur 6 dargestellt. Dieses Beispiel bildet einen bidirektionalen Wellenlängenmultiplex/Demultiplex-Baustein (WDM-Baustein), bei dem auf dem gemeinsamen Substrat S nicht nur die Anordnung nach Figur 1 sondern auch ein Empfangsteil ET integriert ist. Die Ausgangsleistung I1 des Halbleiterlasers LD ist in einem Zweig ZW1 einer Streifenwellenleitergabel WLZ auf eine Übertragungsstrecke Us leitbar. Eine aus der Übertragungsstrecke Us zugeführte Leistung I4 mit einer von der Emissionswellenlänge λ e des Lasers LD verschiedenen Wellenlänge λ a wird in dem anderen Zweig ZW2 der Gabel WLZ dem Empfängerteil ET zugeführt. Dieser Empfängerteil besteht aus einer Empfängerdetektoreinrichtung PD4 und einer vorgeschalteteten Filtereinrichtung FE4, die so ausgebildet ist, daß sie die Wellenlänge λ a der zugeführten Leistung I4 durchläßt, gegen die Emissionswellenlänge λe des Lasers LD aber sperrt.

Die Filtereinrichtung FE4 kann wie die Filtereinrichtung FE aus einem Bragg-Gitter bestehen, dessen Gitterkonstante a₄ jedoch so gewählt wird, daß sich eine Verstimmung zwischen den Transmissionskurven dieser beiden Gitter um die halbe Sperrbandsbreite derart ergibt, daß die stabilisierte Emissionswellenlänge λ e des Lasers LD in der Mitte des Sperrbandes des Gitters der Filtereinrichtung FE4 liegt. Die Temperaturdriften der beiden Gitter werden sich bei diesem Baustein kompensieren, wenn ihr räumlicher Abstand zum Laser LD etwa gleich groß gewählt wird. Alterungsbedingte Änderungen der Emissionswellenlänge λ e des Lasers LD werden ebenfalls ausgeregelt.

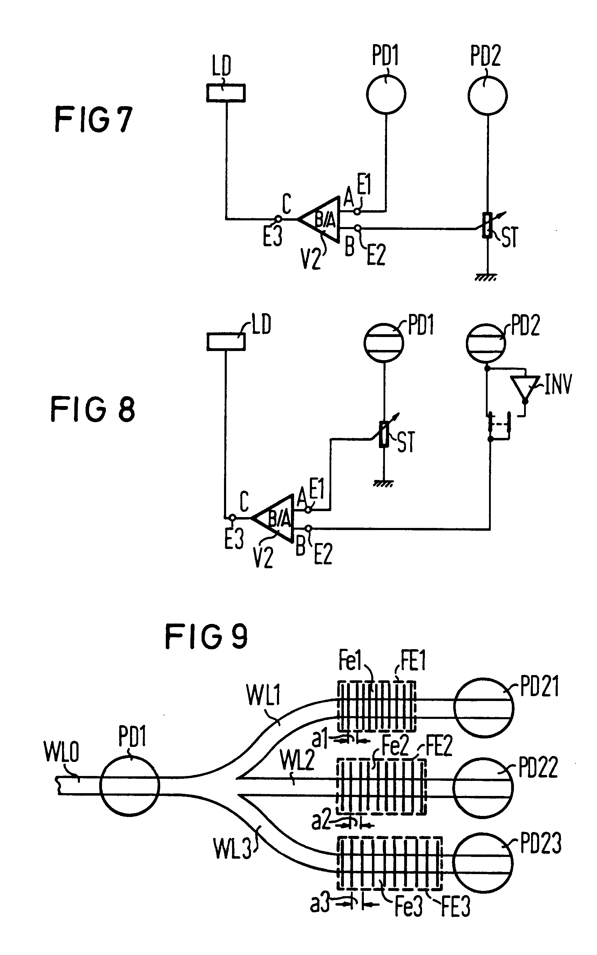

Eine andere Anwendungsmöglichkeit, die für optisches Frequenzmultiplex und Heterodynempfang interessant ist, ist das Durchstimmen der Emissionswellenlänge eines Halbleiterlasers. Durch Einfügen eines variablen Spannungsteilers ST zwischen eine der Detektoreinrichtungen PD1 oder PD2 und den Regelverstärker V2 läßt sich der Arbeitspunkt und damit die Emissionswellenlänge des Halbleiterlasers variieren. In den Figuren 7 und 8 sind zwei solche Schaltungsmöglichkeiten dargestellt.

Im Fall des Durchstimmens ist ein größerer Abstimmbereich und damit ein flacherer Abfall oder Anstieg der Transmissionskurve der Filtereinrichtung FE über dem bestimmten Wellenlängenbereich Be günstiger, als dies bei der Transmissionskurve nach Figur 2 der Fall ist. Dies läßt sich durch ein Bragg-Gitter kürzerer Länge oder ein Bragg-Gitter mit Chirp erreichen. Die Größe des Abstimmbereichs wird dann durch die Abstimmcharakteristik des Lasers LD bestimmt.

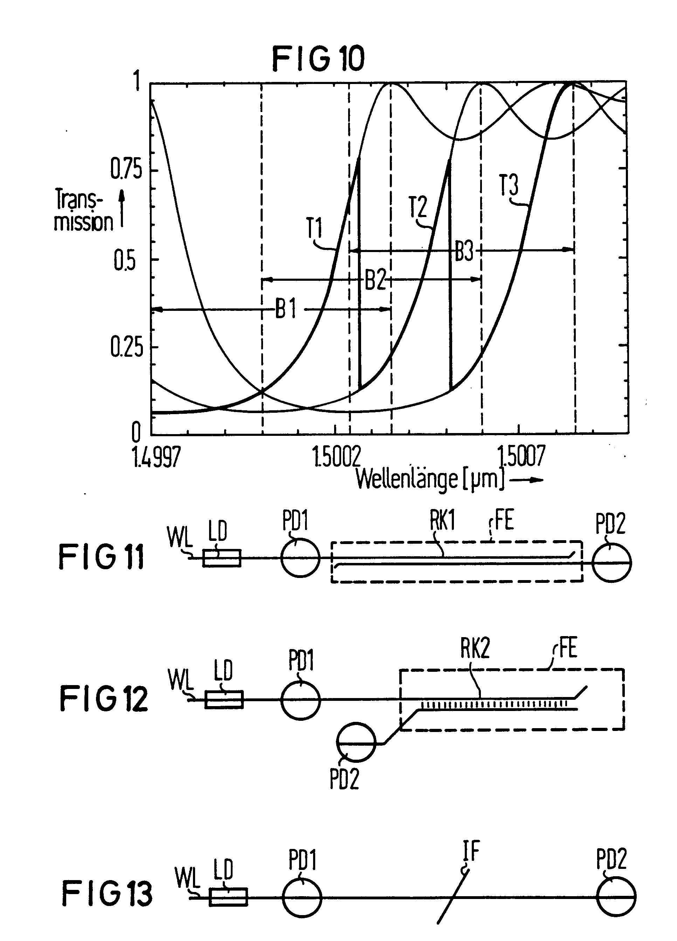

Der Abstimmbereich kann noch vergrößert werden, wenn mehrere parallel geschaltete Filtereinrichtungen FE1, FE2, FE3 verwendet werden. In der Figur 9 ist eine integriert optische Ausführung einer solchen Anordnung in Draufsicht dargestellt. Die vom nicht dargestellten Halbleiterlaser emittierte Leistung wird zumindest teilweise in dem Streifenwellenleiter WL0 der einen Detektoreinrichtung PD1 zugeleitet. Die aus der einen Detektoreinrichtung PD1 austretende Leistung wird durch eine dreifache Streifenwellenleiterverzweigung auf drei Streifenwellenleiter WL1, WL2, WL3 verteilt, auf denen die Filtereinrichtungen FE1, FE2, FE3 in Form von Bragg-Gittern Fe1, Fe2 bzw. Fe3 angeordnet sind. Die durch die Filtereinrichtungen FE1, FE2 und FE3 hindurchgegangenen Leistungen werden in den betreffenden Streifenwellenleiter WL1, WL2, WL3 anderen Detektoreinrichtungen PD21, PD22 bzw. PD23 zugeleitet, die den Filtereinrichtungen jeweils zugeordnet sind.

Die Gitterkonstanten a1, a2 bzw. a3 der drei Bragg-Gitter Fe1, Fe2 und Fe3 werden so gewählt, daß sie verschiedene Transmissionskurven T1, T2 bzw. T3 (siehe Figur 10) mit Anstiegs-oder Abstiegsflanken über verschiedenen Wellenlängenbereichen B1, B2 bzw. B3 aufweisen, die in Richtung zunehmender Wellenlänge aufeinanderfolgen und aneinandergrenzen oder sich überlappen. Das Umschalten von einem Wellenlängenbereich auf einen anderen kann im elektrischen Teil der Anordnung über Schwellwertschalter erfolgen.

Zusätzlich zur beschriebenen Feinabstimmung ist auch noch eine einfache Grobabstimmung dadurch realsierbar, daß zwischen die andere Detektoreinrichtung PD2 und den Regelverstärker V2 ein Inverter INV schaltbar ist, wie es beispielsweise in der Figur 8 angedeutet ist. Dadurch kann eine Anstiegs- oder Abstiegsflanke der Transmissionskurve der Filtereinrichtung der Anordnung gewechselt und die Emissionswellenlänge um den Abstand der betreffenden Flanken der Transmissionskurve im Arbeitspunkt des Lasers geändert werden.

In den vorstehend beschriebenen Anordnungen sind die Filtereinrichtungen durch Bragg-Gitter realisiert. Die Filtereinrichtungen können aber auch mit andersartigen Filtern realisiert werden. Für einen integrierten Aufbau eignen sich ko- und kontradirektionale Richtkoppler. In den Figuren 11 und 12 ist eine Anordnung nach Figur 1 mit derartigen Richtkopplern RK1, RK2 dargestellt. Der Richtkoppler RK1 in Figur 11 ist einkodirektionaler Richtkoppler, bei welchem auf einer Seite einer Koppelstrecke L des Richtkopplers eingekoppelt und auf der anderen Seite dieser Koppelstrecke L ausgekoppelt wird. Der Richtkoppler RK2 nach Figur 12 ist ein kontradirektionaler Richtkoppler, bei dem auf der Seite der Koppelstrecke L ausgekoppelt wird, auf der auch eingekoppelt wird. Derartige Richtkoppler sind bekannt.

Die Figur 13 zeigt eine Anordnung nach Figur 1 mit einem Interferenzfilter IF.

## Patentansprüche

1. Anordnung Zur Steuerung oder Regelung einer Emissionswellenlänge (λ e) und emittierten optischen Leistung (I) eines Halbleiterlasers (LD), wobei die vom Laser (LD) emittierte optische Leistung (I) zumindest teilweise einer ersten optoelektrischen Detektoreinrichtung (PD1) und zumindest einer wellenlängenselektiven optischen Filtereinrichtung (FE; FE1, FE2, FE3) zugeleitet ist, und wobei ein von der Filtereinrichtung (FE; FE1, FE2, FE3) durchgelassener Anteil (I3d; I31d, I32d, I33d) der dieser Filtereinrichtung zugeleiteten Leistung (I3; I31, I32, I33) einer zweiten optoelektrischen Detektoreinrichtung (PD2; PD21, PD22, PD23) zugeleitet ist, dadurch gekennzeichnet
daß der Halbleiterlaser (LD), die Filtereinrichtung (FE; FE1, FE2, FE3) und die erste und zweite Detektoreinrichtung (PD1, PD2, PD21, PD22, PD23) auf einem gemeinsamen Substrat (S) integriert sind,
daß die integrierte Filtereinrichtung (FE; FE1, FE2, FE3) aus einem Bragg-Gitter (Fe, Fe1, Fe2, Fe3) oder einem optischen Richtkoppler (RK1, RK2) oder einem Interferenzfilter (IF) oder aus einer Anordnung aus zwei oder mehreren in Ausbreitungsrichtung der zugeleiteten Leistung (I3) hintereinander angeordneten Bragg-Gittern (Fe, Fe1, Fe2) und/oder optischen Richtkopplern (RK1, RK2) und/oder Interferenzfiltern (IF) besteht,
daß die erste und zweite integrierte Detektoreinrichtung (PD1, PD2, PD21, PD22, PD23) jeweils eine Photodiode aufweist, wobei die emittierte Leistung (I) des integrierten Halbleiterlasers (LD) zumindest teilweise der teildurchlässig ausgebildeten Photodiode der ersten Detektoreinrichtung (PD1) Zugeleitet ist und der durch diese erste Detektoreinrichtung (PD1) hindurchgegangene Teil (I3) der emittierten Leistung (I) der integrierten Filtereinrichtung (FE; FE1, FE2, FE3) zugeleitet ist, und
daß die der integrierten Filtereinrichtung (FE; FE1, FE2, FE3) und der ersten und zweiten integrierten Detektoreinrichtung (PD1, PD2, PD21, PD22, PD23) zugeleiteten optischen Leistungen jeweils in einem auf dem Substrat (S) in Form eines Streifenwellenleiters integrierten optischen Wellenleiter (WL, WL0, WL1, WL2, WL3) geführt sind.

2. Anordnung nach Anspruch 1, **dadurch gekennzeichnet,** daß die integrierte Filtereinrichtung (FE; FE1, FE2, FE3) eine Transmissionskurve (T; 10; T1, T2, T3) aufweist, die über einem bestimmten Wellenlängenbereich, (Be; B0; B1, B2, B3) in den die Emissionswellenlänge (λ e) fällt, einen Anstieg und/oder einen Abfall hat.

3. Anordnung nach Anspruch 2, **dadurch gekennzeichnet,** daß die Transmissionskurve (T0) in dem bestimmten Wellenlängenbereich (B0) eine Spitze (Sp) aufweist.

4. Anordnung nach Anspruch 3, **dadurch gekennzeichnet,** daß die Spitze (Sp) einem zumindest relativen Transmissionsmaximum entspricht.

5. Anordnung nach einem der vorhergehenden Ansprüche, **dadurch gekennzeichnet,** daß ein Bragg-Gitter (Fe) der integrierten Filtereinrichtung (FE) eine variierende Gitterkonstante (a) aufweist.

6. Anordnung nach Anspruch 4 oder 5, **dadurch gekennzeichnet,** daß die Filtereinrichtung (FE) zwei in Ausbreitungsrichtung der ihr zugeleiteten Leistung (I3) hintereinander angeordnete Bragg-Gitter (Fe1, Fe2) aufweist, die in einem Abstand (d) voneinander angeordnet sind, der bezogen auf die optische Weglänge, welche die zugeleitete Leistung (I3) durchläuft, der halben Wellenlänge dieser Leistung oder ein ganzzahliges Vielfaches dieser halben Wellenlänge beträgt.

7. Anordnung nach einem der vorhergehenden Ansprüche, **dadurch gekennzeichnet,** daß eine Filtereinrichtung (FE) oder ein Filterelement (Fe) aus einem ko- oder kontradirektionalen Richtkoppler (RK1, RK2) besteht.

8. Anordnung nach einem der vorhergehenden Ansprüche, **dadurch gekennzeichnet,** daß eine Filtereinrichtung (FE) oder ein Filterelement (Fe) aus einem Interferenzfilter (IF) besteht.

9. Anordnung nach einem der vorhergehenden Ansprüche, **dadurch gekennzeichnet,** daß zwei oder mehrere Filtereinrichtungen (FE1, FE2, FE3) nebeneinander angeordnet sind, denen Teile (I31, I32, I33) der Leistung (I) des Lasers (LD) parallel zugeleitet sind, und daß jeder Filtereinrichtung (FE1, FE2, FE3) je eine andere Detektoreinrichtung (PD21, PD22, PD23) zugeordnet ist, welcher der von der betreffenden Filtereinrichtung (FE1, FE2, FE3) reflektierte oder durchgelassene Anteil (I31a, I32d, I33d) des zugeordneten Teils (I31, I32, I33) der Leistung (I) zugeleitet ist.

10. Anordnung nach Anspruch 9, **dadurch gekennzeichnet,** daß die Filtereinrichtungen (FE1, FE2, FE3) verschiedene Transmissionskurven (T1, T2, T3) mit Anstiegs- oder Abstiegsflanken über verschiedenen Wellenlängenbereichen (B1, B2, B3) aufweisen, die in Richtung zunehmender Wellenlänge aufeinanderfolgen.

11. Anordnung nach Anspruch 10, **dadurch gekennzeichnet,** daß die verschiedenen Wellenlängenbereiche (B1, B2, B3) aneinandergrenzen oder sich überlappen.

12. Anordnung nach einem der vorhergehenden Ansprüche, **dadurch gekennzeichnet,** daß der Laser (LD) die emittierte Leistung (I) nach zwei Seiten emittiert, daß der auf einer Seite emittierte Teil (I1) dieser Leistung als Ausgangsleistung entnehmbar ist.

13. Anordnung nach Anspruch 11 und 12, **dadurch gekennzeichnet,** daß die eine teildurchlässige Detektoreinrichtung (PD1) derart ausgebildet ist, daß sie mehr als 95% der ihr zugeleiteten Leistung (I2) absorbiert.

14. Anordnung nach Anspruch 13, **dadurch gekennzeichnet,** daß die zweite Detektoreinrichtung (PD2; PD21, PD22, PD23) transmittierend ausgebildet ist und daß die Ausgangsleistung des Lasers (LD) der transmittierenden zweiten Detektoreinrichtung entnehmbar ist.

15. Anordnung nach einem der vorhergehenden Ansprüche, **dadurch gekennzeichnet,** daß die der einen oder den einen oder mehreren Filtereinrichtungen (FE; FE1, FE2, FE3) oder Filterelementen (Fe; Fe1, Fe2, Fe3; Fe₁, Fe₂) und den Detektoreinrichtungen (PD1, PD2; PD 21, PD22, PD23) zugeleiteten optischen Leistungen in einem oder mehreren optischen Wellenleitern (WL; WL0, WL1, WL2, WL3) geführt sind.

16. Anordnung nach einem der vorhergehenden Ansprüche, **dadurch gekennzeichnet,** daß die dem Laser (LD) zu entnehmende Ausgangsleistung (I1) in einem Zweig (ZW1) einer Wellenleiterverzweigung (WLZ) fortgeleitet ist, in deren anderem Zweig (ZW2) eine zuzuführende Leistung (I4) mit einer von der Emissionswellenlänge ( λ e) des Lasers (LD) verschiedenen Wellenlänge ( λ a) einer Empfängerdetektoreinrichtung (PD4) zugeleitet ist, der eine Filtereinrichtung (FE4) vorgeschaltet ist, welche die Wellenlänge ( λ a) der zuzuführenden Leistung (I4) durchläßt, gegen die Emissionswellenlänge (λ e) des Halbleiterlasers (LD) aber sperrt.

17. Anordnung nach Anspruch 16, **dadurch gekennzeichnet,** daß die Wellenleiterverzweigung (WLZ) aus einer Streifenwellenleitergabel besteht.

18. Anordnung nach einem der vorhergehenden Ansprüche, **dadurch gekennzeichnet,** daß ein Ausgangssignal (A) der einen Detektoreinrichtung (PD1) zur Steuerung oder Regelung der emittierten Leistung (I) des Lasers (LD) verwendet ist, und daß Ausgangssignale ((A, B) sowohl der einen als auch der einen oder mehreren anderen Detektoreinrichtungen (PD1, PD2, PD21, PD22, PD23) einem Regelverstärker (V2) zugeleitet sind, dessen Ausgangssignal (C) proportional zu einem Quotienten der zugeleiteten Signale (A, B) ist und zur Steuerung der Emissionswellenlänge (λ e) des Lasers (LD) verwendet ist.

19. Anordnung nach Anspruch 18, **dadurch gekennzeichnet,** daß zwischen eine (PD1, PD2) ihrer Detektoreinrichtungen (PD1, PD2, PD21, PD22, PD23) und den Regelverstärker (V2) eine variable Spannungsteilereinrichtung (ST) geschaltet ist.

20. Anordnung nach Anspruch 18 oder 19, **dadurch gekennzeichnet,** daß zwischen zumindest eine andere Detektoreinrichtung (PD2, PD21, PD22, PD23) und den Regelverstärker (V2) ein Inverter (INV) schaltbar ist.

## Claims

1. Arrangement for controlling or regulating an emission wavelength (λ e) and emitted optical power (I) of a semiconductor laser (LD), the optical power (I) emitted by the laser (LD) being conducted at least partially to a first optoelectrical detector device (PD1) and to at least one wavelength-selective optical filter device (FE; FE1, FE2, FE3), and a component (I3d; I31d, I32d, I33d) of the power (I3; I31, I32, I33) conducted to this filter device, which component is transmitted by the filter device (FE; FE1, FE2, FE3), being conducted to a second optoelectrical detector device (PD2; PD21, PD22, PD23), characterised in that the semiconductor laser (LD), the filter device (FE; FE1, FE2, FE3) and the first and second detector device (PD1, PD2, PD21, PD22, PD23) are integrated on a common substrate (S), in that the integrated filter device (FE; FE1, FE2, FE3) comprises a Bragg grating (Fe, Fe1, Fe2, Fe3) or an optical directional coupler (RK1, RK2) or an interference filter (IF) or an arrangement of two or more Bragg gratings (Fe, Fe1, Fe2) arranged in series in the direction of propagation of the conducted power (I3), and/or optical directional couplers (RK1, RK2) and/or interference filters (IF), in that the first and second integrated detector device (PD1, PD2, PD21, PD22, PD23) exhibits in each instance a photodiode, the emitted power (I) of the integrated semiconductor laser (LD) being conducted at least partially to the partially transmitting photodiode of the first detector device (PD1) and that part (I3) of the emitted power (I) which has passed through this first detector device (PD1) being conducted to the integrated filter device (FE; FE1, FE2, FE3), and in that the optical powers which are conducted to the integrated filter device (FE; FE1, FE2, FE3) and to the first and second integrated detector device (PD1, PD2, PD21, PD22, PD23) are guided in each instance in an optical waveguide (WL, WL0, WL1, WL2, WL3) which is integrated on the substrate (S) in the form of a strip waveguide.

2. Arrangement according to Claim 1, characterised in that the integrated filter device (FE; FE1, FE2, FE3) exhibits a transmission curve (T; T0; T1, T2, T3) which over a specified wavelength range (Be; B0; B1, B2, B3), within which the emission wavelength (λ e) falls, has an increase and/or a decrease.

3. Arrangement according to Claim 2, characterised in that the transmission curve (T0) exhibits a peak (Sp) in the specified wavelength range (B0).

4. Arrangement according to Claim 3, characterised in that the peak (Sp) corresponds to an at least relative transmission maximum.

5. Arrangement according to one of the preceding claims, characterised in that a Bragg grating (Fe) of the integrated filter device (FE) exhibits a varying grating constant (a).

6. Arrangement according to Claim 4 or 5, characterised in that the filter device (FE) exhibits two Bragg gratings (Fe1, Fe2) which are disposed in series in the direction of propagation of the power (I3) conducted to it and which are disposed at a spacing (d) from one another, which spacing, related to the optical path length which the conducted power (I3) traverses, amounts to one half of the wavelength of this power or an integral multiple of this half wavelength.

7. Arrangement according to one of the preceding claims, characterised in that a filter device (FE) or a filter element (Fe) comprises a codirectional or contradirectional directional coupler (RK1, RK2).

8. Arrangement according to one of the preceding claims, characterised in that a filter device (FE) or a filter element (Fe) comprises an interference filter (IF).

9. Arrangement according to one of the preceding claims, characterised in that two or more filter devices (FE1, FE2, FE3) are disposed side by side, to which parts (I31, I32, I33) of the power (I) of the laser (LD) are conducted in parallel, and in that with each filter device (FE1, FE2, FE3) there is associated a respective other detector device (PD21, PD22, PD23) to which that component (I31d, I32d, I33d) of the associated part (I31, I32, I32) of the power (I) which is reflected or transmitted by the relevant filter device (FE1, FE2, FE3) is conducted.

10. Arrangement according to Claim 9, characterised in that the filter devices (FE1, FE2, FE3) exhibit differing transmission curves (T1, T2, T3) with increase or decrease flanks over differing wavelength ranges (B1, B2, B3), which follow one another in the direction of increasing wavelength.

11. Arrangement according to Claim 10, characterised in that the differing wavelength ranges (B1, B2, B3) adjoin one another or overlap one another.

12. Arrangement according to one of the preceding claims, characterised in that the laser (LD) emits the emitted power (I) to two sides, in that that part (I1) of this power which is emitted to one side can be taken off as output power.

13. Arrangement according to Claim 11 and 12, characterised in that one of the partially transmitting detector devices (PD1) is designed in such a manner that it absorbs more than 95% of the power (I2) conducted to it.

14. Arrangement according to Claim 13, characterised in that the second detector device (PD2; PD21, PD22, PD23) is designed to be transmitting, and in that the output power of the laser (LD) can be taken off from the transmitting second detector device.

15. Arrangement according to one of the preceding claims, characterised in that the optical powers conducted to the one or to the one or more filter devices (FE; FE1, FE2, FE3) or filter elements (Fe; Fe1, Fe2, Fe3; Fe₁, Fe₂) and the detector devices (PD1, PD2; PD 21, PD22, PD23) are guided in one or more optical waveguides, (WL; WL0, WL1, WL2, WL3).

16. Arrangement according to one of the preceding claims, characterised in that the output power (I1) to be taken off from the laser (LD) is further conducted in a branch (ZW1) of a waveguide branching (WLZ), in the other branch (ZW2) of which a power (I4) to be conducted with a wavelength (λa) differing from the emission wavelength (λe) of the laser (LD) is conducted to a receiver detector device (PD4), upstream of which a filter device (FE4) is disposed, which transmits the wavelength (λa) of the power (I4) to be conducted, but blocks against the emission wavelength (λe) of the semiconductor laser (LD).

17. Arrangement according to Claim 16, characterised in that the waveguide branching (WLZ) comprises a strip waveguide fork.

18. Arrangement according to one of the preceding claims, characterised in that an output signal (A) of one of the detector devices (PD1) is used for controlling or regulating the emitted power (I) of the laser (LD), and in that output signals (A, B) both of the one and also of the one or more other detector devices (PD1, PD2, PD21, PD22, PD23) are conducted to a regulating amplifier (V2), the output signal (C) of which is proportional to a quotient of the conducted signals (A, B) and is used for the control of the emission wavelength (λe) of the laser (LD).

19. Arrangement according to Claim 18, characterised in that a variable voltage divider device (ST) is connected between one (PD1, PD2) of its detector devices (PD1, PD2, PD21, PD22, PD23) and the regulating amplifier (V2).

20. Arrangement according to Claim 18 or 19, characterised in that an invertor (INV) can be switched in between at least one other detector device (PD2, PD21, PD22, PD23) and the regulating amplifier (V2).

## Revendications

1. Dispositif pour commander ou régler une longueur d'onde d'émission (λ e) et une puissance optique émise (I) d'un laser à semiconducteur (LD), dans lequel la puissance optique (I) émise par le laser (LD) est envoyée au moins en partie à un dispositif détecteur optoélectrique (PD1) et au moins à un dispositif de filtrage optique (FE;FE1,FE2,FE3) sélectif du point de vue des longueurs d'onde, et dans lequel une partie (I3d; I31d, I32d, I33d), transmise par le dispositif de filtre (FE; FE1, FE2, FE3), de la puissance (I3, I31, I32, I33) envoyée à ce dispositif de filtre est transmise à un dispositif détecteur opto-électrique (PD2, PD21, PD22, PD23), caractérisé par le fait
que le laser à semiconducteurs (LD), le dispositif de filtre (FE; FE1, FE2, FE3) et les premier et second dispositifs détecteurs (PD1, PD2, PD21, PD22, PD23) sont intégrés sur un substrat commun (S),
que le dispositif de filtre intégré (FE; FE1, FE2, FE3) est constitué par un réseau de Bragg (Fe, Fe1, Fe2, Fe3) ou par un coupleur directionnel (RK1, RK2) ou un filtre interférentiel (IF) ou par un ensemble formé par deux ou plusieurs réseaux de Bragg (Fe, Fe1, Fe2) disposés les uns derrière les autres dans la direction de propagation de la puissance envoyée (I3) et/ou par des coupleurs optiques directionnels (RK1, RK2) et/ou par des filtres interférentiels (IF),
que les premier et second dispositifs détecteurs intégrés (PD1, PD2, PD21, PD22, PD23) possèdent chacun une photodiode, la puissance émise (I) du laser intégré à semiconducteur (LD) étant envoyée au moins en partie à la photodiode qui est agencée de manière à être partiellement transparente, du premier dispositif détecteur (PD1), et la partie (I3), qui traverse le premier dispositif détecteur (PD1), de la puissance émise (I) étant envoyée au dispositif de filtre intégré (FE; FE1, FE2, FE3), et
que les puissances optiques, envoyées au dispositif de filtre intégré (FE; FE1, FE2, FE3) et aux premier et second dispositifs détecteurs intégrés (PD1, PD2, PD21, PD22, PD23), sont transmises respectivement dans un guide d'ondes optiques (WL, WLO, WL1, WL2, WL3), intégré au substrat (S) sous la forme d'un guide d'ondes en forme de bande.

2. Dispositif suivant la revendication 1, caractérisé par le fait que le dispositif de filtre intégré (FE; FE1, FE2, FE3) possède une courbe de transmission (T; T0;T1, T2, T3), qui présente une montée et/ou une descente dans une gamme déterminée de longueurs d'onde (Be; B0; B1, B2, B3), dans laquelle se situe la longueur d'onde d'émission (λ e).

3. Dispositif suivant la revendication 2, caractérisé par le fait que la courbe de transmission (T0) possède une pointe (Sp) dans la gamme déterminée (B0) des longueurs d'onde.

4. Dispositif suivant la revendication 3, caractérisé par le fait que la pointe (Sp) correspond à un maximum de transmission au moins relatif.

5. Dispositif suivant l'une des revendications précédentes, caractérisé par le fait qu'un réseau de Bragg (Fe) du dispositif de filtre intégré (FE) possède une constante de réseau variable (a).

6. Dispositif suivant la revendication 4 ou 5, caractérisé par le fait que le dispositif de filtre (TE) possède deux réseaux de Bragg (Fe1, Fe2) disposés l'un derrière l'autre dans la direction de propagation de la puissance (I3) qui lui est envoyée et qui sont disposés à une distance réciproque (I2) qui, rapportée à la longueur de trajet optique que parcourt la puissance transmise (I3), est égale à la moitié de la longueur d'onde de cette puissance ou à un multiple entier de cette demi-longueur d'onde.

7. Dispositif selon l'une des revendications précédentes, caractérisé en ce qu'un dispositif de filtre (FE) ou un élément de filtre (Fe) est constitué par un coupleur directionnel (RK1, RK2) réalisant un couplage dans un sens ou en sens opposé.

8. Dispositif suivant l'une des revendications précédentes, caractérisé par le fait qu'un dispositif de filtre (FE) ou un élément de filtre (Fe) est constitué par un filtre interférentiel (IF).

9. Dispositif suivant l'une des revendications précédentes, caractérisé par le fait que deux ou plusieurs des dispositifs de filtres (FE1, FE2, FE3) sont disposés côte-à-côte, que des parties (I31, I32, I33) de la puissance (I) du laser (LD) sont envoyées en parallèle à ces dispositifs de filtres et qu'à chaque dispositif de filtre (FE1, FE2, FE3) est associé respectivement un autre dispositif détecteur (PD21, PD22 et PD23), auquel est envoyée la partie (I31d, I32d, I33d), réfléchie ou transmise par le dispositif de filtre concerné (FE1, FE2, FE3), de la partie associée (I31, I32, I33) de la puissance (I).

10. Dispositif suivant la revendication 9, caractérisé par le fait que le dispositif de filtre (FE1, FE2, FE3) possède différentes courbes de transmission (T1, T2, T3) comportant des flancs de montée ou de retombée dans différentes gammes de longueurs d'onde (B1, B2, B3) qui se succèdent dans la direction des longueurs d'onde croissantes.

11. Dispositif suivant la revendication 10, caractérisé par le fait que les différentes gammes de longueurs d'onde (B1, B2, B3) sont contigües ou se chevauchent.

12. Dispositif suivant l'une des revendications précédentes, caractérisé par le fait que le laser (LD) émet la puissance émise (I) de deux côtés et que la partie (I1) de cette puissance, émise d'un côté, peut être prélevée en tant que puissance de sortie.

13. Dispositif suivant les revendications 11 et 12, caractérisé par le fait qu'un dispositif détecteur (PD1) partiellement transparent est agencé de telle sorte qu'il absorbe plus de 95 % de la puissance (I2) qui lui est envoyée.

14. Dispositif suivant la revendication 13, caractérisé par le fait que le second dispositif détecteur (PD2, PD21, PD22, PD23) est agencé de manière à réaliser une transmission et que la puissance de sortie du laser (LD) peut être prélevée du second dispositif détecteur réalisant la transmission.

15. Dispositif suivant l'une des revendications précédentes, caractérisé par le fait que les puissances optiques, qui sont envoyées à un ou à plusieurs dispositifs de filtres (FE; FE1, FE2, FE3) ou éléments de filtres (Fe; Fe1, Fe2, Fe3; Fe₁, Fe₂) et aux dispositifs détecteurs (PD1, PD2; PD21, PD22, PD23) sont transmises dans un ou plusieurs guides d'ondes optiques (WL; WL0, WL1, WL2, WL3).

16. Dispositif suivant l'une des revendications précédentes, caractérisé par le fait que la puissance de sortie (I1), qui doit être prélevée du laser (LD), est transmise dans une branche (ZW1) d'un embranchement de guide d'ondes (WLZ), dans l'autre branche (ZW2) duquel une puissance devant être envoyée (I4) et possédant une longueur d'onde (λ a) qui diffère de la longueur d'onde d'émission (λ e) du laser (LD), est transmise à un dispositif détecteur de réception (PD4), en amont duquel est branché un dispositif de filtre (FE4) qui transmet la longueur d'onde (λ a) de la puissance devant être envoyée (I4), mais réalise un blocage de la longueur d'onde d'émission (λ e) du laser à semiconducteurs (LD).

17. Dispositif suivant la revendication 16, caractérisé par le fait que l'embranchement de guide d'ondes (WLZ) est constitué par un embranchement de guide d'ondes en forme de bande.

18. Dispositif suivant l'une des revendications précédentes, caractérisé par le fait qu'un signal de sortie (A) d'un dispositif détecteur (PD1) est utilisé pour commander ou régler la puissance émise (I) du laser (LD) et que des signaux de sortie (A, B) aussi bien d'un dispositif détecteur que d'un ou de plusieurs autres dispositifs détecteurs (PD1, PD2, PD21, PD22, PD23) sont envoyés à un amplificateur de réglage (V2), dont le signal de sortie (C) est proportionnel à un quotient des signaux envoyés (A, B) et est utilisé pour la commande de la longueur d'onde d'émission (λ e) du laser (LD).

19. Dispositif suivant la revendication 18, caractérisé par le fait qu'entre l'un (PD1, PD2) des dispositifs détecteurs (PD1, PD2, PD21, PD22, PD23) de ce dispositif et l'amplificateur de réglage (V2) est branché un dispositif variable formant diviseur de tension (ST).

20. Dispositif suivant la revendication 18 ou 19, caractérisé par le fait qu'un inverseur (INV) peut être branché entre au moins un autre dispositif détecteur (PD2, PD21, PD22, PD23) et l'amplificateur de réglage (V2).
